(19) Europäisches Patentamt / European Patent Office / Office européen des brevets

(11) **EP 1 337 838 B1**

(12) **EUROPÄISCHE PATENTSCHRIFT**

(45) Veröffentlichungstag und Bekanntmachung des Hinweises auf die Patenterteilung:
**10.01.2007 Patentblatt 2007/02**

(51) Int Cl.:
*G06F 17/50* (2006.01)  *G03F 1/00* (2006.01)
*G06T 7/00* (2006.01)

(21) Anmeldenummer: **01989545.7**

(22) Anmeldetag: **30.11.2001**

(86) Internationale Anmeldenummer:
**PCT/EP2001/014005**

(87) Internationale Veröffentlichungsnummer:
**WO 2002/044699 (06.06.2002 Gazette 2002/23)**

(54) **VERFAHREN UND VORRICHTUNG ZUR BESTIMMUNG VON EIGENSCHAFTEN EINER INTEGRIERTEN SCHALTUNG**

METHOD AND DEVICE FOR DETERMINING THE PROPERTIES OF AN INTEGRATED CIRCUIT

PROCEDE ET DISPOSITIF POUR LA DETERMINATION DE PROPRIETES D'UN CIRCUIT INTEGRE

(84) Benannte Vertragsstaaten:
**AT BE CH CY DE DK ES FI FR GB GR IE IT LI LU MC NL PT SE TR**

(30) Priorität: **30.11.2000 DE 10059516**

(43) Veröffentlichungstag der Anmeldung:
**27.08.2003 Patentblatt 2003/35**

(73) Patentinhaber: **SIGMA-C Software AG 81737 München (DE)**

(72) Erfinder:
- **KALUS, Christian, K.**
  **80797 München (DE)**
- **MALOV, Iouri**
  **81737 München (DE)**

(74) Vertreter: **Hössle Kudlek & Partner Patentanwälte,**
**Postfach 10 23 38**
**70019 Stuttgart (DE)**

(56) Entgegenhaltungen:
WO-A-99/14706    US-A- 5 801 954
US-A- 6 081 659    US-A- 6 091 845

- COLE D.C. ET AL: 'Using Advanced Simulation to Aid Microlithography Development' PROCEEDINGS OF THE IEEE, IEEE. Bd. 89, Nr. 8, August 2001, NEW YORK, US, XP011044542
- WATANABE T. ET AL: 'ENHANCEMENT OF HIERARCHICAL MASK DATA DESIGN SYSTEM (PROPHET)' PROCEEDINGS OF THE SPIE Bd. 3748, September 1999, BELLINGHAM, VA, US, Seiten 196 - 204, XP009066535

EP 1 337 838 B1

## Beschreibung

Die vorliegende Erfindung betrifft ein Verfahren zur Bestimmung von Eigenschaften einer integrierten Schaltung nach dem Oberbegriff des Patentanspruchs 1 sowie eine Vorrichtung nach dem Oberbegriff des Patentanspruchs 8. Die Erfindung betrifft ferner ein Computerprogramm und ein Computerprogrammprodukt mit Programmcode-Mitteln.

Bei der Herstellung höchst integrierter Schaltkreise stößt man mittlerweile an die Auflösungsgrenzen verwendeter Maskenschreiber und/oder optischer Stepper. Es können, beispielsweise bedingt durch physikalische Effekte wie Streuung oder Beugung, Verzerrungen auftreten, welche dazu führen, dass die Figuren auf der Maske in unzulässiger Weise vom Bild eines Entwurfes abweichen. Derartige Abweichungen können letztlich zu elektrischem Fehlverhalten, beispielsweise durch Kurzschlüsse oder Unterbrechungen, führen. Herkömmlicherweise werden vollständige Schaltungsentwürfe von sogenannten DRC-Programmen (engl. Design Rule Check) dahingehend geprüft, ob bzw. inwieweit die Entwurfsregeln eingehalten werden. Zu diesen Entwurfsregeln zählt beispielsweise die kleinste zulässige Größe eines Elements, welche nicht unterschritten werden darf, oder der kleinste zulässige Abstand zwischen benachbarten Strukturen. Die Aufgabe wird von Softwarepaketen gelöst, deren Komplexität von der Ordnung $O(N^2)$ ist, wobei N die Anzahl der Elemente des Schaltungsentwurfs ist. Eine derartige rein geometrische Prüfung fördert Verletzungen von Entwurfsregelungen zutage, beispielsweise Elemente, die sich zu nahe kommen. Eine derartige Überprüfung ist nicht in der Lage, beispielsweise durch den Proximity-Effekt verursachte Störungen aufzudecken. Ein derartiges Verfahren und eine entsprechende Vorrichtung zur Verifikation von Layouts integrierter Schaltkreise sind beispielsweise aus der US 6,115,546 bekannt.

DRC-Verfahren testen die Konsistenz eines Entwurfes gegenüber Entwurfsregeln. Insofern sind DRC-Verfahren nützliche Verfahren zur Prüfung eines strukturierten Ergebnisses. DRC-Verfahren machen jedoch keinerlei Aussage, inwieweit Regelverletzungen auf dem gedruckten Schaltkreis auftreten, verursacht beispielsweise durch mangelnde Auflösung des Projektionsgeräts oder durch den optischen Proximity-Effekt.

Es sind ebenfalls Verfahren bekannt, bei denen kritische Stellen eines Schaltungsentwurfes durch eine Simulation verifiziert werden. Die Verifikation beruht auf der Annahme, dass es innerhalb des Schaltungsentwurfes wenige kritische Objekttypen gibt und dass diese kritischen Typen, beispielsweise Kontaktlöcher, vorher bekannt sind. Unter diesen Voraussetzungen, die in der Halbleiterforschung und -herstellung bis vor kurzem regelmäßig gegeben waren, lässt sich die Verifikation durch Simulation durchführen. Sobald die Technologie via Simulation soweit optimiert wurde, dass die kritischen Typen sich ordentlich abbilden und ein genügend großes Prozessfenster besitzen, schließt man, dass der gesamte Schaltkreis funktionieren muss.

Der Simulationsaufwand zur Verifikation der Integrität des Schaltkreisentwurfes steigt jedoch an, nicht so sehr durch die zunehmende Größe der Schaltungen, sondern mehr durch die sogenannten "Reticle Enhancement Techniken". Hierzu zählt die optische Proximity-Korrektur, die eine erhebliche Änderung des Entwurfes bedeutet. Bei heutigen modernen Entwürfen, insbesondere Logikentwürfen und insbesondere solchen nach Proximity-Korrektur, gilt die Annahme nicht mehr, man habe mit wenigen kritischen Figurtypen, beispielsweise Kontaktlöchern oder Verbindungslinien, alle Problemstellen im Griff. Die Verhältnisse werden durch das lokale Anbringen von "Serifen" und Hilfsstrukturen leicht unüberschaubar und führen zu unentdeckten Schwachstellen (sogenannten Weak Spots). Hier liegt eine der wichtigsten Anwendungen für die vorliegende Erfindung.

In der Halbleiterfertigung werden Inspektionsgeräte serienmäßig eingesetzt zur Prüfung von Masken und der eigentlichen, auf Siliziumscheiben gedruckten Schaltkreise. Die Aufgabe der Inspektionsgeräte besteht darin, Defekte, beispielsweise Staubkörner, zu finden. Derartige Inspektionsgeräte sind beispielsweise aus der US 5,563,702 und der US 5,619,429 bekannt. Derartige Geräte arbeiten in der Regel nach einem der zwei im folgenden beschriebenen Verfahren:

Bei einem ersten Verfahren werden zwei Schaltkreise miteinander vergleichen (engl. Die-to-Die), indem man nach sorgfältiger Justierung der Schaltkreise gegeneinander diese mit einem feinen Laserstrahl abrastert bzw. abtastet. Findet man hierbei Unterschiede zwischen den beiden Schaltkreisen, werden diese anschließend klassifiziert und als defekt erkannt. Mit diesem Verfahren ist es nicht möglich, systematisch bedingte Abweichungen festzustellen, da diese in beiden Schaltkreisen auftreten können.

Das zweite herkömmlicherweise verwendete Verfahren verwendet einen Vergleich des Schaltkreises mit einer Datenbasis (engl. Die-to-Database). Bei derartigen Verfahren wird der zu untersuchende Schaltkreis optisch abgetastet, und die erhaltenen Signale werden mit einer Sollgeometrie eines Entwurfes verglichen. Dieses Verfahren ist in der Lage, Defekte auch dann festzustellen, wenn kein Referenzobjekt vorliegt. Da jedoch die Gefahr besteht, dass Abweichungen gegenüber der Sollgeometrie des Entwurfes als Defekte interpretiert werden, ist es möglich, dass prozessbedingte Abweichungen fälschlicherweise als Defekte interpretiert werden.

Keines der dargestellten Verfahren ist dafür ausgelegt oder in der Lage, prozessbedingte Unterschiede zwischen dem geplanten Entwurf und dem strukturierten Objekt bzw. Schaltkreis zu erkennen. Ein weiteres Kennzeichen sämtlicher herkömmlicher Inspektionsverfahren besteht darin, dass sie lediglich passiv wirken, also keine aktive Änderung, insbesondere keine Verbesserung eines bestehenden Entwurfes, vorsehen oder vorschlagen können.

Die erwähnten Inspektionsgeräte sind dafür ausgelegt, Defekte zu finden. Sie setzen im Prinzip eine funktionierende Prozesstechnologie voraus. Die implizite Voraussetzung für die Realisierung eines Inspektionsgerätes gängiger Bauart ist, dass die Geometrie des Entwurfes verzerrungsfrei auf eine Siliziumscheibe übertragen wird. Mit anderen Worten wird sowohl der Maskenherstellungsprozess als auch die Strukturierung auf der Siliziumscheibe durch einen optischen Projektionsapparat (Stepper) als ideal angenommen. An der Vorderfront der gegenwärtigen Technologie ist aber genau diese Voraussetzung nicht mehr gegeben, so dass gedruckte Schaltungen mehr und mehr von ihren jeweiligen Entwürfen abweichen. Dies liegt zum einen darin begründet, dass die optische Abbildungsapparatur als Tiefpassfilter wirkt, und zum anderen daran, dass alle nachfolgenden Prozessglieder, wie beispielsweise Fotolacke und verwendete Ätztechniken, stets mehr Verzerrungen liefern.

Zur Erfassung von Abweichungen der Prozesstechnologie gibt es den traditionellen Weg "Versuch und Irrtum", bei welchem eine Schaltung tatsächlich gedruckt und das Ergebnis punktuell inspiziert wird. Da dieser Weg sehr kostenintensiv ist, geht man seit einigen Jahren dazu über, über Simulationen eine Vorhersage bezüglich einer sich bei einem durchzuführenden Herstellungsprozess tatsächlich ergebenden Schaltung zu machen. Gegenwärtige optische Mikrolithographiesimulatoren arbeiten sehr genau, erfordern aber einen sehr hohen Rechenaufwand. Daher ist eine Simulation nur in einem mikroskopisch kleinen Bereich, typischerweise mehrere $\mu m^2$, durchzuführen. Da man insbesondere bei großen integrierten Schaltungen in der Regel nicht weiß, welche konkreten Stellen eines Entwurfes kritisch sind, ist eine derartige Simulation, welche beispielsweise nur in bestimmten Bereichen durchgeführt wird, kein hinreichender Test für die Richtigkeit bzw. Funktionsfähigkeit einer Schaltung.

Aus der WO 99/14706 ist ein Verfahren zur Überprüfung der Integrität einer integrierten Schaltung bekannt, bei dem ein rechnerisch simuliertes Lackbild, das bei der Belichtung einer Maske entstehen würde, mit einem simulierten Lackbild, das vom ursprünglichen Entwurf ausgehend berechnet wird, verglichen wird.

Die US-A-6 091 845 beschreibt ein ähnliches Verfahren, bei dem das erste simulierte Lackbild ausgehend von einem Bild einer realen Maske erzeugt wird.

Weitere Verfahren zur Simulation eines Maskenprozesses sind beispielsweise aus der US 6,081,659 und der US 5,801,954 bekannt.

Als objektive technische Aufgabe ergibt sich, eine alternative Möglichkeit zur Überprüfung der Integrität einer integrierten Schaltung bereitzustellen.

Die Erfindung strebt insbesondere an, Entwürfe elektronischer Schaltungen als Ganzes in vertretbarer Zeit, vorzugsweise als Nachtlauf, bei Kenntnis der geplanten Prozesstechnologie, insbesondere der vollständigen Prozesstechnologie, zu simulieren.

Diese Aufgabe wird gelöst durch ein Verfahren mit den Merkmalen des Patentanspruchs 1, eine Vorrichtung mit den Merkmalen des Patentanspruchs 8, ein Computerprogramm mit den Merkmalen des Patentanspruchs 12 und ein Computerprogrammprodukt mit dem Merkmalen des Patentanspruchs 13.

Erfindungsgemäß erhält man ein virtuelles bzw. simuliertes Bild einer integrierten Schaltung, welche mit einem gedachten bzw. ursprünglichen Entwurf der Schaltung verglichen werden kann. Erfindungsgemäß ist es in einfacher Weise möglich, die Stellen der (simulierten) Schaltung anzugeben, die um mehr als einen entsprechenden Toleranzwert von einem Soll abweichen.

Durch Verwendung der erfindungsgemäßen Lehre ist ferner eine automatische Schwachstellenerkennung zur Verfügung gestellt, da man nicht mehr, wie dies bei bisherigen Verfahren der Fall war, gezwungen ist, die Stellen eines Entwurfes genau anzugeben, an denen simuliert werden soll (bislang war dies notwendig, da die Gebiete, die bisher mit vertretbarem Rechenaufwand simulierbar waren, sehr klein waren). Dies erforderte bei bisherigen Verfahren vom Anwender die Kenntnis der latenten Schwachstellen. Erfindungsgemäß ist es möglich, die zu simulierenden Flächen gegenüber herkömmlichen Lösungen um mehrere Größenordnungen zu vergrößern.

Durch Anwendung des erfindungsgemäßen Verfahrens ist es möglich, einen Schaltkreisentwurf bzw. die Prozessbedingungen zu seiner Herstellung so zu verbessern, dass Schwachstellen minimiert werden können, oder im günstigsten Fall sogar ganz verschwinden. Hierbei sind zweckmäßigerweise technologisch wichtige Randbedingungen, wie beispielsweise Designregeln oder Prozessfenster, zu berücksichtigen.

Vorteilhafte Ausführungsformen der Erfindung sind Gegenstand der Unteransprüche.

Erfindungsgemäß als rechnerisch simuliertes Bild ein Lackbild der Schaltung bereitgestellt.

Erfindungsgemäß wird hierbei das simulierte Lackbild mit Hilfe einer eine bei Belichtung sich gleichmäßig in alle Richtungen ausbreitende Lackoberfläche in einem zu simulierenden Resist bzw. Photoresist beschreibenden Oberflächenfunktion bereitgestellt. Diese Annahme erweist sich für die Durchführung der im Rahmen der erfindungsgemäßen Simulation verwendeten Rechnungen als sehr günstig. Herkömmlicherweise wurde bei rechnerischen Simulationen stets davon ausgegangen, dass eine Ausbreitung der Lackoberfläche zunächst senkrecht zur Lackoberfläche, und anschließend parallel zu dieser erfolgte. Abgesehen davon, dass ein derartiges Modell die physikalische Realität nur unzureichend beschreibt, war der hiermit verbundene Rechenaufwand sehr groß.

Es ist bevorzugt, dass das simulierte Bild, insbesondere das Lackbild, unter Verwendung einer Gleichung der Form

$$\left(\frac{\partial S}{\partial x}\right)^2 + \left(\frac{\partial S}{\partial y}\right)^2 + \left(\frac{\partial S}{\partial z}\right)^2 = \left(\frac{I(0)}{I(x,y,z)}\right)^{2\gamma}\left(\frac{1}{r_0}\right)^2$$

berechnet wird. Hierbei ist $I(x,y,z)$ die Intensität des zur Belichtung des Resists verwendeten Lichtes an einem Ort $(x,y,z)$ des Resists, $I(0)$ eine aus einer Beziehung $I(0)=E_0/E$ ableitbare Referenzintensität (wobei $E$ die einfallende Lichtdosis an einem Ort $(x,y,z)$ und $E_0$ eine Referenzdosis darstellt, $\gamma$ ein Sensitivitäts- bzw. Nichtlinearitätsparameter, welcher insbesondere die Nichtlinearität eines Entwicklungs- bzw. Resistprozesses beschreibt, und $r_0$ ein aus der Beziehung $D_{eff}=r_0 \cdot t$ ableitbarer Faktor ist, wobei $D_{eff}$ eine effektive Resistdicke und $t$ die Entwicklungszeit ist. Die hiermit angegebene partielle Differentialgleichung erweist sich als numerisch oder analytisch lösbar, wobei insbesondere die analytische Lösungsmöglichkeit gegenüber herkömmlichen Verfahren wesentlich geringere Rechenzeiten erfordert.

Zweckmäßigerweise wird von einer Intensitätsverteilung der Form $I(x,y,z)=I(x,y)e^{-\alpha z}$ ausgegangen. Diese Annahme wird als Dünnfilmnäherung bezeichnet. Es wird davon ausgegangen, dass die chemische Zusammensetzung des betrachteten Resists homogen ist, wofür sich ein Absorptionsgesetz angeben lässt. Unter dieser Annahme lässt sich die Oberflächenfunktion $S(x,y,z)$ in der Form $S(x,y)e^{\alpha\gamma z}$ angeben.

Gemäß einer bevorzugten Ausführungsform des erfindungsgemäßen Verfahrens wird bei der Berechnung des rechnerisch simulierten Bildes der Schaltung die Annahme gemacht, dass $\gamma \gg 1$ ist. Mit dieser Annahme ist die oben angegebene partielle Differentialgleichung für $S(x,y,z)$ in besonders einfacher Weise analytisch lösbar. Die Bedingung $\gamma \gg 1$ folgt bzw. lässt sich ableiten aus experimentellen Daten, wenn $\gamma$ als Sensitivität des verwendeten Resists angesehen wird.

Mit der Annahme $\gamma \gg 1$ lässt sich eine Lösung der genannten partiellen Differentialgleichung in der Form

$$S(x,y,z) = \frac{1}{r_0\gamma}\left(\frac{E_0}{EI(x,y,z)}\right)^\gamma \frac{1}{\sqrt{\left(\frac{\partial\ln I}{\partial x}\right)^2 + \left(\frac{\partial\ln I}{\partial y}\right)^2 + \left(\frac{\partial\ln I}{\partial z}\right)^2}}$$

angeben. Hierbei stellen die Werte $S(x,y,z)=t$ die Flächen des entwickelten Resistprofils zu einer festen Entwicklungszeit $t$ (ausgehend vom Zeitpunkt $t=0$ zu Beginn der Entwicklung) dar.

Gemäß einer besonders bevorzugten Ausführungsform des erfindungsgemäßen Verfahrens wird das entwickelte Resistprofil dargestellt als

$$z(x,y) = d\left(1 - \frac{1}{\alpha\gamma d}\ln\left(1 + D_{eff}\gamma\left(\frac{EI(x,y)}{E_0}\right)^\gamma F(x,y)\right)\right),$$

wobei gilt

$$F(x,y) = \sqrt{\left(\frac{\partial\ln I(x,y)}{\partial x}\right)^2 + \left(\frac{\partial\ln I(x,y)}{\partial y}\right)^2 \div \alpha^2}.$$

Bei dieser Gleichung wurde von der Dünnfilmnäherung bzw. einer Beschreibbarkeit der Intensität $I$ in der Form

$$I(x, y, z) = I(x, y)e^{-\alpha z}$$

ausgegangen.

Gemäß einer weiteren bevorzugten Ausführungsform des erfindungsgemäßen Verfahrens wird eine den Entwurf beschreibende hierarchisch strukturierte Dateneingangsmenge verarbeitet, wobei insbesondere das simulierte Bild ebenfalls in Form einer hierarchischen Strukturierung bereitgestellt wird. Hiermit ist der Rechenaufwand bzw. die Rechenzeit gegenüber herkömmlichen Verfahren weiter verkürzbar.

Gemäß einer bevorzugten Ausführungsform der erfindungsgemäßen Vorrichtung weist diese Mittel zur insbesondere automatischen Änderung von Simulationsparametern auf. Mit derartigen Mitteln ist es möglich, eine zunächst unzureichende Simulation in optimaler Weise zur Konvergierung zu bringen.

Die Erfindung wird nun anhand der beigefügten Zeichnung weiter erläutert. In dieser zeigt

Figur 1     beispielhaft Details einer integrierten Schaltung in Draufsicht bzw. in perspektivischer Ansicht,

Figur 2     ein Flussdiagramm zur Darstellung einer bevorzugten Ausführungsform des erfindungsgemäßen Verfahrens,

Figur 3     Lackbilder, welche unter Verwendung einer herkömmlichen vollen Simulation bzw. unter Verwendung des erfindungsgemäßen Verfahrens berechnet ist, und

Figur 4     ein Diagramm zum Vergleich der bei Anwendung des erfindungsgemäßen Verfahrens benötigten Rechenzeit mit der bei herkömmlichen Verfahren benötigten Rechenzeit jeweils als Funktion der berechneten bzw. simulierten Fläche.

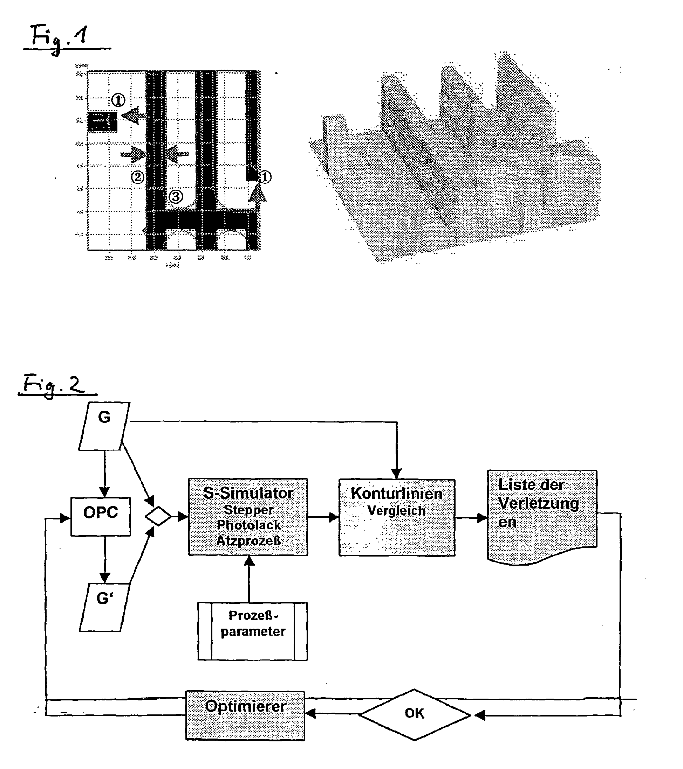

Figur 1, links, zeigt einen Ausschnitt aus einem Entwurf einer integrierten Schaltung. Die Schaltungsbereiche sind schwarz dargestellt. Die entsprechenden Bereiche sind in der rechten Darstellung als reliefartige Bereiche sichtbar. Es sei davon ausgegangen, dass es sich bei der rechten Darstellung um die zugehörige Lackstruktur handelt, die unter spezifischen Belichtungsbedingungen erhalten wurde. Schneidet man das Bild horizontal am Fuß des Lackes, so erhält man die punktiert dargestellten Schnittlinien der linken Darstellung. Die Gegenüberstellung zeigt, dass das Ergebnis dieses Lithographieschnittes, die sogenannte Lackmaske, vom Entwurf deutlich abweichen kann. Einige Regelverletzungen sind durch Zahlen markiert. So bezeichnet 1 eine auftretende Linienverkürzung, 2 deutet auf Linienbreitenänderungen, und 3 auf Eckenverrundungen hin.

Derartige Regelverletzungen müssen innerhalb gewisser Toleranzbereiche liegen. In Figur 1 wurde beispielhaft eine Lackmaske mit einem Entwurf verglichen. Die Herstellung einer Lackmaske stellt einen Teil eines vollständigen Herstellungsprozesses für eine integrierte Schaltung dar. Typische Schritte sollen an dieser Stelle kurz zusammengefasst werden:

Zunächst wird ein Entwurf einer Schaltung mittels eines Maskenschreibers auf eine Maske übertragen. Durch Verwendung dieser Maske in einem optischen Projektionsapparat, einem sogenannten Stepper, wird die Maskenstruktur auf eine mit einer Lack- und Schichtstruktur beschichtete Siliziumscheibe projiziert. Das hierbei auf der Höhe der Lackoberfläche entstehende Bild wird als Luftbild bezeichnet. Genauer gesagt beschreibt das Luftbild die dreidimensionale Intensitätsverteilung des Lichts in der Nähe der Lackoberfläche. Es ist möglich, unter Berücksichtigung unter anderem von Projektionsparametern das entstehende Luftbild rechnerisch zu simulieren. Eine derart ausgeführte Belichtung des Lacks bzw. des Resists führt zu einer fotochemischen Reaktion der belichteten Teile des Lackes. Bei Simulation des Belichtungsschrittes wird aus dem Luftbild berechnet, wie die optischen Wellen, abhängig von der Lack- und Schichtstruktur, auf der Siliziumscheibe reflektiert werden und stehende Wellen bilden. Aus dieser Intensitätsverteilung wird berechnet, wie die fotoempfindliche Komponente des Lacks reagiert und zu einer neuen Ausgangskomponente führt, deren Konzentrationskarte in einem latenten Bild gespeichert wird (Lackbild). Anschließend wird bei einem Tempern die Diffusion der Reaktionsprodukte berechnet und gleichzeitig die Reaktionskinetik des chemischen Verstärkungsmechanismus berechnet. Anschließend wird das latente Bild (Lackbild) nasschemisch entwickelt, so dass eine dauerhafte Lackstruktur entsteht. Auch eine Simulation des Entwicklungsprozesses ist möglich. Diese Lackstruktur dient in der Regel beim folgenden Ätzen als Lackmaske. Somit ist eine dauerhafte Struktur im Silizium entstanden (Ätzbild), während alle vorherigen Bilder flüchtigen Charakter aufweisen. Es ist ebenfalls möglich, den Ätzvorgang zu simulieren.

Das Ätzen wird heute in der Praxis meist als reaktives Ionenätzen durchgeführt.

Anhand der Figur 2 wird nun das Prinzip des erfindungsgemäßen Simulationsverfahrens beschrieben.

Die Inspektion einer integrierten bzw. bedruckten Schaltung bezüglich vorhandener Regelverletzungen lässt sich dadurch erzielen, dass der Entwurf, beschrieben durch eine Geometriemenge {G} oder eine bezüglich eines optischen Proximity-Effektes korrigierte Geometriemenge {G'}, in eine Simulationsvorrichtung eingebracht wird, welche eine Geometriemenge {G''} berechnet, welche wählbaren Ansichten der integrierten Schaltung entspricht. Hierzu verwendet die Simulationsvorrichtung verschiedene Modelle für die Prozessschritte und die zugehörigen Parameter. Als mögliche Ansichten sind beispielsweise die bereits erwähnten Luftbilder, Lackbilder oder Ätzbilder zu nennen. Der Vergleich auf Korrektheit der simulierten bzw. berechneten integrierten Schaltung lässt sich erreichen, indem man die Geometriemenge {G2'} mit dem ursprünglich gedachten Entwurf {G} vergleicht. Hierzu ist es beispielsweise möglich, die Konturlinien in der Menge {G2'} zu berechnen und mit dem Entwurf {G} zu vergleichen. Wichtig ist beim Vergleich, dass, sofern eine Proximity-Korrektur durchgeführt wurde, der Vergleich gegenüber der Menge {G}, und nicht gegenüber den Eingangsdaten {G'} durchgeführt wird. Dabei kann anstelle der Menge {G} auch ein Satz von Entwurfsregeln verwendet werden. In diesem Fall werden die Entwurfsregeln erweitert um Prozessregeln, die ebenfalls erfüllt sein müssen. Hierzu zählt beispielsweise die Regel, dass die Schärfentiefe im Lithographieprozess ein Minimum nicht unterschreiten darf. Treten Regelverletzungen auf, werden sie zweckmäßigerweise in einer Liste protokolliert und ausgegeben.

Das Ergebnis des Vergleichs kann in einer Liste von Regelverletzungen angegeben werden. Je nach Ergebnis dieses Vergleiches bzw. Inhalt der Liste können die Prozessparameter mittels eines Optimierers modifiziert werden, so dass eine modifizierte Simulation durchgeführt werden kann. Diese Möglichkeit ist in Figur 2 schematisch dargestellt.

Wie bereits ausgeführt, strebt die Erfindung an, die Simulation zu beschleunigen, indem wenigstens einer der Einzelschritte der Simulation durch einen geeigneten schnellen Algorithmus berechnet wird. Gemäß der vorliegenden Erfindung wird dabei eine schnelle Lackbildberechnung angestrebt.

Die Erfindung gibt erstmals analytische Lösungen bzw. Näherungen an, die gegenüber bisher verwendeten nicht-analytischen (d. h. numerischen) Verfahren um Größenordnungen schneller sind. Es ist jedoch auch möglich, die erfindungsgemäß vorgeschlagenen Gleichungen numerisch zu lösen, wobei auch hier die Rechnungen gegenüber herkömmlichen Lösungen wesentlich schneller durchzuführen sind. Als Beispiel sei auf ein Verfahren zur schnellen Berechnung eines Lackbildes (d. h. Simulation eines Entwicklungsprozesses) hingewiesen. Hierbei wird erfindungsgemäß davon ausgegangen, dass sich die Lackoberfläche (beispielsweise während der Entwicklung) in alle Richtungen ausbreitet. Dies bedeutet, dass sich ein Lackbereich, der sich aufgrund der Belichtung chemisch verändert bzw. chemisch verändert wurde, in alle Richtungen ausdehnt. Bei herkömmlichen Modellen war davon ausgegangen, dass sich die Lackoberfläche zunächst in einer Richtung (beispielsweise senkrecht zur Lackoberfläche), und anschließend in eine hierzu senkrechte Richtung (beispielsweise parallel zur Lackoberfläche) ausbreitet. Die erfindungsgemäße Annahme der Ausbreitung der Lackoberfläche in alle Richtungen führt zu einer Vereinfachung der Algorithmen, wie weiter unten noch im einzelnen ausgeführt wird. Es sei darauf hingewiesen, dass die Geschwindigkeit der Ausbreitung vom Kontrast des verwendeten Resists sowie der (x,y,z)-Verteilung der Intensität im Resist abhängt. Unter der Annahme, dass in der durch die Belichtung definierten Richtung (d. h. senkrecht zur Resistoberfläche) die Dünnfilmnäherung anwendbar ist, gemäß welcher die chemische Zusammensetzung des Resists homogen ist (hierfür lässt sich ein Absorptionsgesetz angeben), lässt sich die Geschwindigkeit der Ausbreitung der Lackoberfläche in Abhängigkeit von einer (x,y)-Verteilung der Intensität beschreiben. Mit x bzw. y sind linear unabhängige Richtungen parallel zur Lackoberfläche bezeichnet.

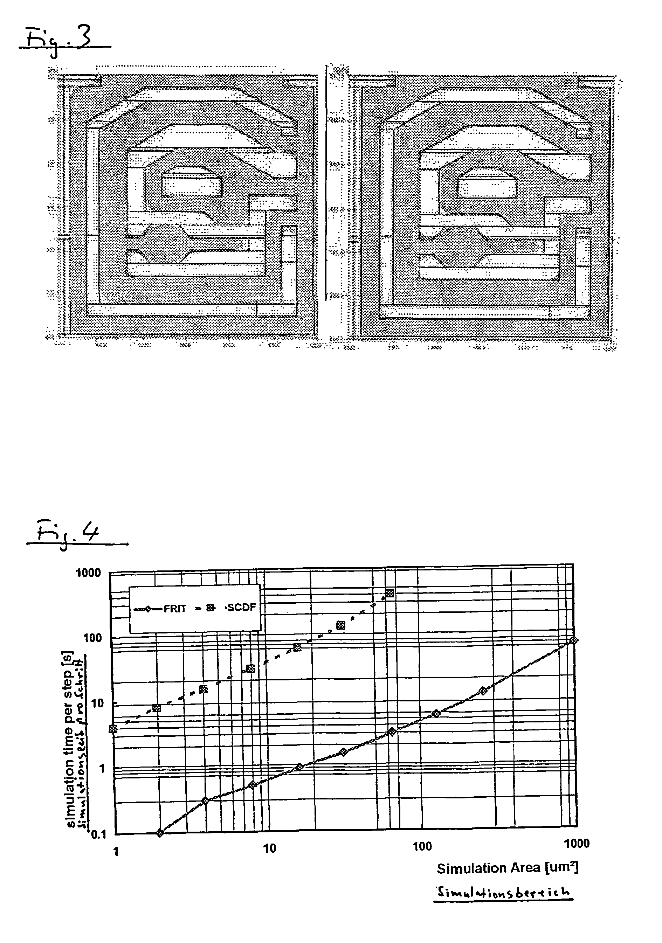

Es wird in diesem Zusammenhang auf die Figur 3 hingewiesen. Hier sind jeweils Simulationen von horizontalen Schnitten durch den Fotolack nach der Entwicklung dargestellt. Das linke Bild ist durch eine vollständige numerische Simulation entstanden, das rechte durch die erfindungsgemäß vorgeschlagene schnelle Näherung unter Verwendung der oben beschriebenen Annahmen. Man erkennt, dass die Unterschiede zwischen den beiden Bildern minimal sind, wobei jedoch der erfindungsgemäß realisierbare Zeitgewinn erheblich ist. In der gegenwärtigen Ausprägung beträgt der Zeitvorteil und mithin der Flächengewinn etwa zwei Größenordnungen. Dies ist in Figur 4 dargestellt. Hier ist für herkömmliche Verfahren (punktierte Linie) und die erfindungsgemäße schnelle Näherung (durchgezogene Linie) die benötigte Rechenzeit als Funktion der Fläche dargestellt. Auf der logarithmischen Y-Achse ist abzulesen, dass der Geschwindigkeitszuwachs etwa zwei Größenordnungen beträgt.

Die der erfindungsgemäßen Simulation zugrundeliegenden mathematischen Zusammenhänge sollen im folgenden weiter erläutert werden.

Es wird hierbei beispielhaft der Fall einer Ausbreitung eines Konturprofils (bzw. einer Oberfläche) im Fotoresist während eines Entwicklungsprozesses betrachtet.

Die Ausbreitung eines Konturprofils kann im Rahmen einer stationären Level-Set-Formulierung beschrieben werden. Es sei zunächst vom zweidimensionalen Fall ausgegangen, bei welchem die Oberfläche bzw. das sich ausbreitende Konturprofil eine sich ausbreitende Kurve ist. Es wird zunächst das evolvierende bzw. sich ausbreitende Null-Level-Set über der X-Y-Ebene erzeugt. Es sei $S(x,y,z)$ die Entwicklungszeit $t$, an welcher die Kurve den Punkt $(x,y,z)$ kreuzt. Die Oberfläche $S(x,y,z)$ erfüllt in diesem Fall die durch Osher und Sethian (J.A. Sethian, Level Set Methods, University of California, Berkeley, 1996) eingeführte Gleichung

$$|\nabla S|r = 1 \qquad\qquad (1)$$

wobei r die Geschwindigkeitsfunktion bzw. eine die Entwicklungsrate des Resists beschreibende Funktion ist.

Wenn die Geschwindigkeitsfunktion r lediglich von der Position abhängt, erhält man die aus der Optik bekannte Eikonalgleichung. Schließlich ist die Position der Front $\Gamma$ durch das Level-Set der Zeit der Funktion S(x,y,z) definiert, wodurch man

$$\Gamma(t) = \left\{ (x, y, z) \,\middle|\, S(x, y, z) = t \right\} \qquad (2)$$

erhält. Die Form des sich schließlich ergebenden Resistprofils kann aus den Gleichungen (1) und (2) berechnet werden, wobei zweckmäßigerweise die Geschwindigkeitsfunktion als Entwicklungsratenfunktion definiert wird, welche die Entwicklungsrate r(x,y,z) als Funktion der Intensität I(x,y,z) des Luftbildes beschreibt:

$$r(x, y, z) = r_0 \left( \frac{I(x, y, z)E}{E_0} \right)^{\gamma} = r_0 \left( \frac{I(x, y, z)}{I(0)} \right)^{\gamma} \qquad (3)$$

Hierbei ist E die in großen, unbedeckten bzw. freien Flächen des Resistes bzw. der Resistoberfläche gegebene Dosis, $E_0$ eine Schwellendosis (insbesondere für die Auslösung einer Entwicklung des Resists), $r_0$ die Entwicklungsrate, welche aus der Bedingung $E \cdot I = E_0$ resultiert, und $\gamma$ ein Nichtlinearitätsparameter bzw. Sensitivitätsparameter, welcher die Nichtlinearität bzw. Sensitivität des Resists bzw. des Resistentwicklungsprozesses beschreibt.

Es wird nun eine effektive Resistdicke $D_{eff} = r_0 t$ eingeführt. Mathematisch ausgedrückt gilt $I(0) = E_0/E$.

Man erhält so eine Intensität I(x,y,z) des Luftbildes, welches in der üblichen Weise normiert ist, wobei I(x,y,z) $\rightarrow$ 1 in großen freien Flächen gilt.

Erfindungsgemäß wird nun vorgeschlagen, die Gleichung (3) in die Gleichung (1) einzufügen bzw. zu substituieren, wodurch sich ergibt:

$$|\nabla S| r_0 = \left( \frac{I(0)}{I(x, y)} \right)^{\gamma} \qquad (4)$$

Im zweidimensionalen Fall erhält man so

$$\left( \frac{\partial S}{\partial x} \right)^2 + \left( \frac{\partial S}{\partial y} \right)^2 = \left( \frac{I(0)}{I(x, y)} \right)^{2\gamma} \left( \frac{1}{r_0} \right)^2 \qquad (5)$$

Man kann leicht zeigen, dass Gleichung (5) sich im eindimensionalen Fall auf die durch Mack in "Enhanced Lumped Parameter Model for Photolithography, SPIE, Vol. 2197/501, 1994" angegebene Gleichung reduziert, wenn der Absorptionskoeffizient vernachlässigt wird.

Gleichung (5) kann auch auf den dreidimensionalen Fall ausgedehnt werden. Insgesamt erhält man hierbei die Gleichung

$$\left( \frac{\partial S}{\partial x} \right)^2 + \left( \frac{\partial S}{\partial y} \right)^2 + \left( \frac{\partial S}{\partial z} \right)^2 = \left( \frac{I(0)}{I(x, y, z)} \right)^{2\gamma} \left( \frac{1}{r_0} \right)^2 \qquad (6)$$

Geht man nun, wie oben bereits erwähnt, davon aus, dass in z-Richtung die Dünnfilmnäherung anwendbar ist, welche sich als

$$I(x, y, z) = I(x, y)e^{-\alpha z} \qquad (7)$$

beschreiben lässt, wobei $\alpha$ der Absorptionskoeffizient des betrachteten bzw. zu simulierenden Resists ist, lässt sich S (x,y,z) in der folgenden Form darstellen:

$$S(x, y, z) = S(x, y)e^{\alpha \gamma z} \qquad (8)$$

Gleichung (6) lässt sich in diesem Falle darstellen als

$$\left(\frac{\partial S}{\partial x}\right)^2 + \left(\frac{\partial S}{\partial y}\right)^2 + a^2 \gamma^2 S^2 = \left(\frac{I(0)}{I(x, y)}\right)^{2\gamma} \left(\frac{1}{r_0}\right)^2 \qquad (9).$$

Aus Gleichung (9) sind Randbedingungen erhältlich, wann es möglich ist, den den Absorptionskoeffizienten enthaltenden Term zu vernachlässigen:

$$\alpha \gamma x_{kante} \ll 1$$

$$\alpha \gamma y_{kante} \ll 1 \qquad (10),$$

wobei $x_{Kante}$ und $y_{Kante}$ die Orte der jeweiligen Resistkanten sind.

Unter der Annahme, dass $\gamma \gg 1$ ist, lässt sich die das Resistprofil S(x,y,z) beschreibende Gleichung (6) in einfacher Weise analytisch lösen, wobei, wie bereits erwähnt, angenommen wird, dass $\gamma$ die Sensitivität des verwendeten Fotoresists darstellt. $\gamma$ kann in an sich bekannter Weise beschrieben werden durch eine Betrachtung der Beziehung zwischen der Dosis des auf den Resist einwirkenden Lichts und der Tiefe des Resists (betrachtet ausgehend von der Resistoberfläche).

Unter der genannten Annahme $\gamma \gg 1$ lässt sich die Lösung der Gleichung (6) in der folgenden Form darstellen:

$$S(x, y, z) = \frac{1}{r_0 \gamma} \left(\frac{E_0}{EI(x, y, z)}\right)^{\gamma} \frac{1}{\sqrt{\left(\frac{\partial \ln I}{\partial x}\right)^2 + \left(\frac{\partial \ln I}{\partial y}\right)^2 + \left(\frac{\partial \ln I}{\partial z}\right)^2}} \qquad (11)$$

Die Flächen

$$S(x, y, z) = t \qquad (12)$$

beschreiben das entwickelte Resistprofil für eine bestimmte Entwicklungszeit t. Die Randbedingung für die Gleichung (12) besteht darin, dass S(x,y,z) auf der ursprünglichen Resistoberfläche verschwindet.

Gleichung (11) stellt die allgemeine Lösung der Gleichung (6) dar. Geht man nun von einer Intensität I(x,y,z) aus, wie sie in Gleichung (7) beschrieben ist, erhält man aus den Gleichungen (11) und (12) die folgende Gleichung für das entwickelte Resistprofil:

$$z(x,y) = d\left(1 - \frac{1}{\alpha\gamma d}\ln\left(1 + D_{eff}\gamma\left(\frac{EI(x,y)}{E_0}\right)^{\gamma}F(x,y)\right)\right) \qquad (13).$$

Hierbei ist F(x,y) darstellbar in der Form

$$F(x,y) = \sqrt{\left(\frac{\partial\ln I(x,y)}{\partial x}\right)^2 + \left(\frac{\partial\ln I(x,y)}{\partial y}\right)^2 + \alpha^2} \qquad (14).$$

Ferner ist d die Resistdicke, $D_{ff}$ die oben erwähnte effektive Resistdicke und $\alpha$ der Absorptionskoeffizient des Resists

Es sei an dieser Stelle noch einmal darauf hingewiesen, dass das so berechnete bzw. simulierte Resistprofil von der Intensität des Luftbildes I(x,y) abhängt.

Insgesamt erhält man erfindungsgemäß eine sehr einfache analytische Beziehung für eine Definition bzw. Darstellung eines Resistprofils ohne die Notwendigkeit der Einführung oder Betrachtung chemischer Parameter. Das vorgestellte Verfahren beruht ausschließlich auf physikalischen Konzeptionen und Parametern und erlaubt eine sehr schnelle Berechnung eines Resistprofils für große Flächen. Das vorgestellte Modell ist um zwei Größenordnungen schneller als herkömmliche volle Simulationen eines Resistprofils, welche auf chemischen Konzeptionen basieren.

Mit dem hiermit vorgestellten Algorithmus lassen sich Simulationen von Lackbildern gegenüber herkömmlichen Verfahren wesentlich beschleunigen. Die Gleichungen (6) oder (9) lassen sich analytisch oder numerisch lösen, wobei die beiden Lösungsarten gegenüber herkömmlich verwendeten Modellen bzw. Algorithmen wesentlich schneller und effektiver abzuarbeiten sind.

Der Vollständigkeit halber seien noch einige Anmerkungen zu der Level-Set-Formulierung angefügt. Es ist wie oben unter Gleichung (2) angegeben, möglich, eine stationäre Level-Set-Gleichung zu formulieren, wobei die Position der Front $\Gamma$ durch das Level-Set des Wertes t der Funktion S(x,y,z) gegeben ist, wie aus Gleichung (2) folgt. In der zeitabhängigen Level-Set-Gleichung ist die Position der Front $\Gamma$ zu einem Zeitpunkt t gegeben durch das Null-Level-Set einer Funktion $\rho$ zu einem Zeitpunkt t, d. h. $\Gamma(t)=\{(x,y)|\rho(x,y,t)=0\}$.

Gemäß einer weiteren Variante der Erfindung, welche beispielsweise zusätzlich oder alternativ zu dem oben beschriebenen Algorithmus einsetzbar ist, lässt sich die Simulation weiter beschleunigen, indem man eine im Entwurf vorhandene Hierarchie ausnutzt. Die im Entwurf vorhandene Hierarchie kann man dadurch ausnutzen, indem man auf geeignete Weise den Hierarchiebaum von unten nach oben Blatt für Blatt abarbeitet und gleichzeitig für Stetigkeit an den Blatträndern sorgt. Auf diese Weise lässt sich, abhängig vom Hierarchiegrad, die Rechenzeit um mehrere Größenordnungen reduzieren.

Eine wesentliche Idee beim hierarchischen Abarbeiten besteht darin, anstelle eines expandierten, flachen Entwurfes auf dem Hierarchiebaum selbst zu arbeiten. Enthält der Entwurf viele sich wiederholende Strukturen, so werden statt der vielen einzelnen Strukturen nur die verschiedenen Typen abgespeichert. An der Stelle ihres Auftretens verweist ein Zeiger auf die jeweilige Struktur.

Ein Hauptproblem hierarchischer Bearbeitung besteht darin, Stetigkeit an den Grenzen der Zellen (bzw. Blätter) zu gewährleisten. Nach dem nun vorgeschlagenen Verfahren geschieht dies dadurch, dass man vor der eigentlichen Datenverarbeitung jede Zelle mit einem Saum umgibt, der der Reichweite der zu berücksichtigenden physikalischen Effekte entspricht, welche gerade bearbeitet werden bzw. in Betracht gezogen werden müssen.

Diese Vorstufe ist nützlich, weil man nun die Nachbarschaft einer Zelle bei der Berechnung des Zellinhalts berücksichtigen kann. Anschließend wird der Saum nicht mehr gebraucht. Die Hinzunahme des Saums erfasst verschiedene Nachbarschaften, je nachdem, wo die Zelle aufgerufen wird. Dies bedeutet, dass die Hierarchie zu einem gewissen Grad zerfällt. Zu diesem Zweck erweist es sich als zweckmäßig, einen Hierarchiefaktor einzuführen, der quantitativ bestimmt, wie groß der Kompaktierungsgrad ist, wenn man den Hierarchiebaum mit dem flachen Entwurf vergleicht. Zweckmäßigerweise wird dieser Faktor definiert durch

$$PHF_{subtree} = \frac{n}{nSVar} \qquad (15),$$

wobei n die Anzahl aller Elemente im flachen Entwurf, und $n_{SVar}$ die entsprechende Menge im Baum oder einem Ast des Baumes ist. Per Definition ist PHF größer oder gleich 1. Man kann $n_{SVar}$ berechnen, nachdem die Vorstufe durchlaufen wurde, um anschließend richtig entscheiden zu können, ob man zweckmäßigerweise eine flache oder hierarchische Behandlung durchführt. Ist der veränderte Baum erzeugt worden, der die Zellen und Varianten der Zellen enthält, die sich nicht im Zellinhalt, sondern lediglich in ihrer Nachbarschaft unterscheiden, kann die eigentliche Berechnung des physikalischen Effekts beginnen, indem man alle Zellvarianten durchrechnet. Wenn PHF deutlich größer als 1 ist, gewinnt man eben diesen Faktor an Zeit.

Der weiter oben erwähnte Vergleich der Geometriemengen {G''} mit {G} bzw. {G'} erfordert beispielsweise eine Abstandsberechnung innerhalb einer Figur entlang der gekrümmten Konturlinien und einen Vergleich mit einer geradlinigen Sollgeometrie. Ebenso ist eine Abstandsberechnung von Nachbar zu Nachbar entlang gekrümmter Konturlinien und Vergleich mit einer geradlinigen Sollgeometrie durchzuführen. Nach der Erfindung werden diese Berechnungen ebenfalls auf einer hierarchischen Datenmenge durchgeführt.

Damit lässt sich die Rechenzeit wieder erheblich verkürzen, bzw. die nutzbare Fläche vergrößern. Das Vergleichsergebnis wird zweckmäßigerweise in einer Koordinatenliste mit Ist- und Sollwert des Abstands angegeben. Die Listen werden nach der Erfindung nach verschiedenen Gesichtspunkten sortiert, um mögliche gemeinsame Ursachen für die Verletzungen erkennen zu lassen. Häufigkeitsverteilungen werden erstellt auf der (x,y)-Ebene, gruppiert beispielsweise nach Zellen oder Figurentyp, z. B. Einzellinien, Stege und Gräben, oder Kontaktlöcher.

Nach der Erfindung können die Regelverletzungen minimiert werden, indem man den Inspektionsvorgang wiederholt durchführt, nachdem gezielte Änderungen an den Prozessbedingungen angebracht bzw. eingestellt wurden. Hierzu bestimmt das System nach der Methode des steilsten Gradienten die Parameteränderungen, die am meisten Besserung bewirken. In der ersten Ausbaustufe ist ein halbautomatischer Betrieb vorgesehen, bei dem der Benutzer die Wiederholung des Vorgangs auslöst. In einer zweiten Ausbaustufe wird die Optimierung automatisch durchgeführt, solange bis das Verfahren konvergiert hat. Die Abbruchkriterien können nach der Erfindung aus einem gewissen Vorrat vom Benutzer ausgewählt werden.

Bei Anwendung des erfindungsgemäßen Verfahrens ist es möglich, einen Hierarchiebaum eines Entwurfes bei der simulierenden Datenverarbeitung weitgehend beizubehalten. Die Schwierigkeit besteht darin, dass man bei strenger hierarchischer Behandlung, d. h. dem zellweisen Bearbeiten, so rechnet, als habe die Zelle keine Nachbarschaft. Abhängig vom physikalischen Effekt haben Nachbarzellen jedoch einen unterschiedlich weit reichenden Einfluss auf die zu bearbeitende Zelle, wie bereits erwähnt wurde.

Der vorgeschlagene Weg gemäß der Erfindung besteht also darin, die möglichen unterschiedlichen Nachbarschaften für jede Zelle zu erzeugen und in einem neuen Hierarchiebaum zu speichern. Derartige Varianten der Zellen werden als Kacheln bezeichnet. Jede Kachel ist also mit einem Saum umgeben, der der Weite des Einflussbereiches der Nachbarzellen auf eine betrachtete Zelle entspricht. Der entstandene Baum ist in der Regel weniger kompakt als der ursprüngliche, stellt aber die kompakteste Beschreibung des Hierarchiebaumes für den Fall dar dass man die zugrundeliegenden physikalischen Effekte zur Kenntnis nimmt, welche natürlich an Zellgrenzen nicht halt machen.

In dem neu entstandenen Hierarchiebaum kann man nun alle Kacheln einzeln bezüglich des physikalischen Effektes bearbeiten. Nach Abschneiden der Säume erhält man den Entwurf im Bild des untersuchten physikalischen Effekts. Die Zeitersparnis gegenüber herkömmlichen Lösungen ist in erster Näherung gegeben durch das Verhältnis der Summe der Flächen im Kachelbaum zur Fläche des entfalteten Entwurfs.

Als Beispiel sei die Berechnung des Luftbildes genannt. Zunächst werden die Kacheln erzeugt, wobei der Einflussbereich in diesem Fall durch die Reichweite der optischen Interferenzen gegeben ist. Nach der Theorie der Lichtbeugung schätzt man die Reichweite ab, indem man z. B. vorgibt, dass die Intensität der Nebenmaxima unter einen Schwellwert von z. B. 1% gefallen ist. In der Praxis wählt man einen Bereich von $n·\lambda/Na$ aus, wobei n in der Gegend von 10 liegt. Sind alle Kacheln einschließlich der Säume berechnet, kann man anschließend die Säume abschneiden und erhält nach dem Ausbreiten des ganzen Hierarchiebaums das Luftbild des vollständigen Entwurfs.

Nach der Erfindung kann man die Liste der Verletzungen von Regeln, die man bei einem Vergleich eines simulierten Bildes mit dem ursprünglichen Entwurf erhält, dazu benutzen, eine Optimierung durchzuführen. Bisherige Algorithmen für die Schritte Bildentstehung, Bildübertragung und Strukturübertragung sind nicht geschlossen analytisch formulierbar. Nach der Erfindung gibt es analytische Beschreibungen für die drei Arbeitsschritte. Diese Funktionen sind ebenfalls differenzierbar, so dass man einen Lösungsvektor für die Verbesserung des Verhaltens angeben kann.

In einem ersten Schritt hat der Benutzer beispielsweise manuell die Möglichkeit, einen Satz von Parametern zu wählen, der optimiert werden soll. Im Gegensatz zu bestehenden Verfahren der linearen Optimierung ist das erfindungsgemäße Verfahren hier nicht-iterativ, sofern die Ableitung linear ist. Ist sie iterativ, weist sie ein wesentlich schnelleres Konvergenzverhalten als herkömmliche Verfahren bzw. Algorithmen auf.

In einem zweiten Schritt läuft die Optimierung selbständig ab. Hierzu werden alle Ableitungen gebildet an den Orten maximaler Regelverletzungen und anschließend die Parameter herausgefiltert, die besonders starke Veränderungen bewirken.

Bestehende Inspektionsapparate, insbesondere die in der Beschreibungseinleitung erwähnten Inspektionsapparate vom Typ "Die-to-Database", sind für die vorliegende Erfindung besonders interessant, da sie einen Vergleich zwischen einer Sollstruktur und einem tatsächlichen Bild durchführen. Mit der erfindungsgemäßen Vorrichtung (Inspektionsapparat) wird jedoch kein echtes, gemessenes Bild zur Verfügung gestellt, sondern ein berechnetes bzw. simuliertes. Man muss also die oben genannten Schritte Bildentstehung, Bildübertragung und Strukturübertragung virtuell durchführen, d. h. das Bild oder die Teilbilder dem Inspektionsapparat in der Form anbieten, wie entsprechend der Berechnung bzw. Simulation das gemessene Bild aussieht. Der folgende Vergleich findet auf die selbe Weise statt wie beispielsweise bei herkömmlichen "Die-to-Database"-Inspektionsapparaten. Die oben erläuterten Algorithmen werden als dezidierte Hardwaremodule realisiert, wobei der Parallelisierung der Module hohe Bedeutung zukommt, da der Messvorgang gegenüber der Rechnung sehr viel schneller abläuft. Die Optimierung wird behandelt wie bei der Lösung als Softwareprogramm.

Das erfindungsgemäß vorgeschlagene Verfahren gleicht also dem obengenannten Inspektionsverfahren "Die-to-Database". Die Erfindung fördert im Gegensatz zu dem genannten Verfahren jedoch keine Defekte einer tatsächlichen Schaltung oder einer Maske zutage, sondern die systembedingten Abweichungen des Technologieprozesse, sowie Schwachstellen des Entwurfs bzw. des durch Proximity-Korrektur geänderten Entwurfs.

Mittels der Erfindung ist es unter anderem in einfacher Weise möglich, aus den berechneten Bildern die Schwachstellen automatisch herauszufiltern und in einer Liste abzulegen.

Erfindungsgemäß erweist es sich als besonders vorteilhaft, dass man die Bestimmung der Abstände von Objekten im Rahmen der simulierten Schaltung (bzw. deren Vergleich mit dem Schaltungsentwurf) auf jeder Bildebene durchführen kann. Das hat bei der Realisierung des dargestellten Algorithmus den Vorteil des stufenweisen Vorgehens. Man kann also beispielsweise die Analyse auf der Ebene des Luftbildes, des Lackbildes bzw. latenten Bildes oder des Ätzbildes bzw. Strukturbildes durchführen.

Die Abstandsberechnung wird hierbei zweckmäßigerweise in zwei Stufen durchgeführt. Zunächst wird das Innere der Figur durchlaufen und geprüft, ob sich die Breiten innerhalb einer vorgegebenen Bandbreite bewegen (üblicherweise $\pm 10\%$). Anschließend werden die Abstände zwischen den Figuren berechnet, wobei wiederum auf die Entwurfsregeln zu achten ist und/oder der Vergleich mit dem ursprünglichen Entwurf durchgeführt werden muss.

**Patentansprüche**

1. Verfahren zur rechnerischen Bestimmung der Integrität einer integrierten Schaltung, wobei ein rechnerisch simuliertes Lackbild der Schaltung zur Vorhersage bezüglich einer sich bei einem Herstellungsprozess tatsächlich ergebenden Schaltung mit einem ursprünglichen Entwurf der Schaltung verglichen wird, und Abweichungen zwischen dem simulierten Lackbild und dem Entwurf, die um mehr als einem Toleranzwert von einem Soll abweichen, festgestellt werden,
   **dadurch gekennzeichnet, dass**
   das simulierte Lackbild mit Hilfe einer eine bei Belichtung sich gleichmaßig in alle drei Raumrichtungen ausbreitende Lackoberfläche in einem zu simulierenden Resist beschreibenden Oberflächenfunktion S(x,y,z), berechnet wird.

2. Verfahren nach Anspruch 1, **dadurch gekennzeichnet, dass** das simulierte Lackbild, unter Verwendung einer Gleichung der Form

$$\left(\frac{\partial S}{\partial x}\right)^2 + \left(\frac{\partial S}{\partial y}\right)^2 + \left(\frac{\partial S}{\partial z}\right)^2 = \left(\frac{I(0)}{I(x,y,z)}\right)^{2\gamma}\left(\frac{1}{r_0}\right)^2 \qquad (6)$$

   berechnet wird, wobei I(x,y,z) die Intensität des zur Belichtung des Resists verwendeten Lichtes an einem Ort (x, y,z) des Resists, I(0) eine aus der Beziehung I(0)=$E_0$/E ableitbare Referenzintensität, wobei E die einfallende Lichtdosis in großen, freien Bereichen des Resists und $E_0$ ein Schwellwert ist, $\gamma$ ein Nichtlinearitätsparameter, welcher insbesondere die Nichtlinearität eines Entwicklungs- bzw. Resistprozesses beschreibt, und $r_0$ ein aus der Beziehung $D_{eff}$=$r_0 \cdot$t ableitbarer Faktor ist, wobei $D_{eff}$ eine effektive Resistdicke und t die Entwicklungszeit ist, ist.

3. Verfahren nach einem der vorstehenden Ansprüche, **dadurch gekennzeichnet, dass** von einer Intensitätsverteilung im Resist der Form I (x, y, z)=I(x, y)$e^{-\alpha z}$ ausgegangen wird.

4. Verfahren nach einem der vorstehenden Ansprüche, **dadurch gekennzeichnet, dass** das rechnerisch simulierte Lackbild unter der Annahme $\gamma \gg 1$ berechnet wird.

5. Verfahren nach einem der vorstehenden Ansprüche, **dadurch gekennzeichnet, dass** das rechnerisch simulierte Lackbild der Schaltung unter Verwendung einer Gleichung der Form

$$S(x,y,z) = \frac{1}{r_0 \gamma} \left( \frac{E_0}{EI(x,y,z)} \right)^{\gamma} \frac{1}{\sqrt{\left( \frac{\partial \ln I}{\partial x} \right)^2 + \left( \frac{\partial \ln I}{\partial y} \right)^2 + \left( \frac{\partial \ln I}{\partial z} \right)^2}} \qquad (11)$$

berechnet wird.

6. Verfahren nach einem der vorstehenden Ansprüche, **dadurch gekennzeichnet, dass** das rechnerisch simulierte Lackbild unter Verwendung einer Gleichung der Form

$$z(x,y) = d \left( 1 - \frac{1}{\alpha \gamma d} \ln \left( 1 + D_{eff} \gamma \left( \frac{EI(x,y)}{E_0} \right)^{\gamma} F(x,y) \right) \right) \qquad (13)$$

berechnet wird, wobei gilt

$$F(x,y) = \sqrt{\left( \frac{\partial \ln I(x,y)}{\partial x} \right)^2 + \left( \frac{\partial \ln I(x,y)}{\partial y} \right)^2 + \alpha^2} \qquad (14).$$

7. Verfahren nach einem der vorstehenden Ansprüche, **dadurch gekennzeichnet, dass** eine den Entwurf beschreibende hierarchisch strukturierte Dateneingangsmenge verarbeitet wird, wobei insbesondere das simulierte Lackbild ebenfalls in Form einer hierarchischen Strukturierung bereitgestellt wird.

8. Vorrichtung zur rechnerischen Bestimmung der Integrität einer integrierten Schaltung, **gekennzeichnet durch** ein Computerprogramm, das nach einem Verfahren gemäß einem der Ansprüche 1 bis 7 ein rechnerisch simuliertes Lackbild der Schaltung berechnet und das simulierte Bild mit einem Entwurf der Schaltung vergleicht, wenn das Computerprogramm auf der genannten Vorrichtung ausgeführt wird.

9. Vorrichtung nach Anspruch 8, **gekennzeichnet durch** Mittel zur automatischen Änderung von Simulationsparametern.

10. Computerprogramm mit Programmcodemitteln, welches das Verfahren nach wenigstens einem der Ansprüche 1 bis 7 durchführt, wenn das Computerprogramm auf einem Computer oder einer Rechnereinheit ausgeführt wird.

11. Computerprogrammprodukt mit Programmcode-Mitteln, die auf einem computerlesbaren Datenträger gespeichert sind, welches das Verfahren nach wenigstens einem der Ansprüche 1 bis 7 durchführt, wenn das Computerprogrammprodukt auf einem Computer ausgeführt wird.

**Claims**

1. Process for the determination of the integrity of an integrated circuit by calculation, wherein a resist image of the circuit simulated by calculation is compared with an original design of the circuit in order to make predictions concerning a circuit which will actually be obtained in a manufacturing process, and deviations between the simulated resist image and the design which differ from a rated value by more than a tolerance value are detected, **characterised in that** the simulated resist image is calculated with the aid of a surface function S(x,y,z) which describes a uniform propagation in all three space directions of a resist surface in a resist which is to be simulated under illumination.

2. Process according to claim 1, **characterised in that** the simulated resist image, is calculated using an equation of the form

$$\left(\frac{\partial S}{\partial x}\right)^2 + \left(\frac{\partial S}{\partial y}\right)^2 + \left(\frac{\partial S}{\partial z}\right)^2 = \left(\frac{I(0)}{I(x,y,z)}\right)^{2\gamma}\left(\frac{1}{r_0}\right)^2 \qquad (6),$$

wherein I(x,y,z) is the intensity of the light used to illuminate the resist at a point (x,y,z) of the resist, I(0) is a reference intensity which can be derived from the equation $I(0)=E_0/E$, where E is the incident light dose in large exposed areas of the resist and $E_0$ is a threshold, $\gamma$ is a nonlinearity parameter which particularly describes the nonlinearity of a developing or resist process, and $r_0$ is a factor which can be derived from the equation $D_{eff}=r_0 \cdot t$, wherein $D_{eff}$ is an effective resist thickness and t is the developing time.

3. Process according to any one of the preceding claims, **characterised in that** it starts from an intensity distribution in the resist of the form $I(x,y,z)=I(x,y)e^{-\alpha z}$.

4. Process according to any one of the preceding claims, **characterised in that** the resist image simulated by calculation is calculated on the assumption $\gamma>>1$.

5. Process according to any one of the preceding claims, **characterised in that** the resist image simulated by calculation of the circuit is calculated using an equation of the form

$$S(x,y,z) = \frac{1}{r_0\gamma}\left(\frac{E_0}{EI(x,y,z)}\right)^\gamma \frac{1}{\sqrt{\left(\frac{\partial \ln I}{\partial x}\right)^2 + \left(\frac{\partial \ln I}{\partial y}\right)^2 + \left(\frac{\partial \ln I}{\partial z}\right)^2}} \qquad (11)$$

6. Process according to any one of the preceding claims, **characterised in that** the resist image simulated by calculation is calculated using an equation of the form

$$z(x,y) = d\left(1 - \frac{1}{\alpha\gamma d}\ln\left(1 + D_{eff}\gamma\left(\frac{EI(x,y)}{E_0}\right)^\gamma F(x,y)\right)\right) \qquad (13)$$

wherein

$$F(x,y) = \sqrt{\left(\frac{\partial \ln I(x,y)}{\partial x}\right)^2 + \left(\frac{\partial \ln I(x,y)}{\partial y}\right)^2 + \alpha^2} \qquad (14).$$

7. Process according to any one of the preceding claims,

**characterised in that** a hierarchically structured data input set describing the design is processed, wherein particularly the simulated resist image is also provided in the form of a hierarchical structuring.

8. Apparatus for determination of the integrity of an integrated circuit by calculation, **characterised by** a computer program which, according to a process according to any one of claims 1 to 7, calculates a resist image simulated by calculation of the integrated circuit, and compares the simulated image with a design of the circuit, when the computer program is run on said apparatus.

9. Apparatus according to claim 8, **characterised by** means for automatically changing simulation parameters.

10. Computer programme with programme coding means, which performs the process according to any one of claims 1 to 7, when the computer program is run on a computer or a computer unit.

11. Computer programme product with programme coding means which are stored on a computer-readable data carrier, which carries out the process according to any one of claims 1 to 7, when the computer programme product is run on a computer.

**Revendications**

1. Procédé pour la détermination par calcul de l'intégrité d'un circuit intégré, dans lequel une image en laque du circuit simulée par calcul est comparée avec un projet initial du circuit en vue d'une prédiction par rapport à un circuit qui résulte effectivement d'un processus de fabrication, et des écarts entre l'image en laque simulée et le projet, qui s'écartent de plus d'une valeur de tolérance par rapport à une valeur de consigne, sont constatés,
**caractérisé en ce que**
l'image en laque simulée est calculée à l'aide d'une fonction de surface S (x,y,z) qui décrit une surface de laque qui se propage lors d'une illumination régulièrement dans toutes les trois directions dans l'espace, dans un agent résistant qu'il s'agit de simuler.

2. Procédé selon la revendication 1, **caractérisé en ce que** l'image en laque simulée est calculée en utilisant une équation de la forme :

$$\left(\frac{\delta S}{\delta x}\right)^2 + \left(\frac{\delta S}{\delta y}\right)^2 + \left(\frac{\delta S}{\delta z}\right)^2 = \left(\frac{I(0)}{I(x,y,z)}\right)^{2\gamma}\left(\frac{1}{r_0}\right)^2 \qquad (6)$$

dans laquelle I (x,y,z) est l'intensité de la lumière utilisée pour l'illumination de l'agent résistant à un emplacement (x,y,z) de l'agent résistant, I(0) est une intensité de référence qui peut être dérivée de l'équation $I(0) = E_0/E$, E étant la dose de lumière incidente dans les grandes zones libres de l'agent résistant et $E_0$ est en une valeur seuil, $\gamma$ est un paramètre de non-linéarité qui décrit en particulier la non-linéarité d'un processus de développement ou d'agent résistant, et $r_0$ est un facteur qui peut être dérivé de la relation $D_{eff} = r_0.t$, dans laquelle $D_{eff}$ et une épaisseur effective de l'agent résistant et t est le temps de développement.

3. Procédé selon l'une des revendications précédentes, **caractérisé en ce que** l'on suppose une distribution d'intensité dans l'agent résistant sous la forme $I (x,y,z) = I (x,y) e^{-\alpha z}$.

4. Procédé selon l'une des revendications précédentes, **caractérisé en ce que** l'image en laque simulée par calcul est calculée en supposant que y >> 1.

5. Procédé selon l'une des revendications précédentes, **caractérisé en ce que** l'image en laque du circuit simulée par calcul est calculée en utilisant une équation de la forme

$$S(x,y,z) = \frac{1}{r_0 \gamma} \left( \frac{E_0}{EI(x,y,z)} \right)^\gamma \frac{1}{\sqrt{\left( \frac{\delta \ln I}{\delta x} \right)^2 + \left( \frac{\delta \ln I}{\delta y} \right)^2 + \left( \frac{\delta \ln I}{\delta z} \right)^2}} \qquad (11).$$

6. Procédé selon l'une des revendications précédentes, **caractérisé en ce que** l'image en laque simulée par calcul est calculée en utilisant une équation de la forme

$$z(x,y) = d\left( 1 - \frac{1}{\alpha \gamma d} \ln\left( 1 + D_{eff} \gamma \left( \frac{EI(x,y)}{E_0} \right)^\gamma F(x,y) \right) \right) \qquad (13)$$

et dans ce cas s'applique

$$F(x,y) = \sqrt{\left( \frac{\delta \ln I(x,y)}{\delta x} \right)^2 + \left( \frac{\delta \ln I(x,y)}{\delta y} \right)^2 + \alpha^2} \qquad (14).$$

7. Procédé selon l'une des revendications précédentes, **caractérisé en ce que** l'on traite un groupe d'entrée de données à structure hiérarchique décrivant le projet, et dans lequel l'image en laque simulée est en particulier également préparée sous la forme d'une structuration hiérarchique.

8. Appareil pour la détermination par calcul de l'intégrité d'un circuit intégré,
   **caractérisé en ce que**,
   un programme d'ordinateur calcule, d'après un procédé selon l'une des revendications 1 à 7, une image en laque du circuit simulée par calcul, et compare l'image simulée avec un projet du circuit, lorsque le programme d'ordinateur est exécuté sur l'appareil mentionné.

9. Appareil selon la revendication 8, **caractérisé par** des moyens pour modifier automatiquement des paramètres de simulation.

10. Programme d'ordinateur comprenant des moyens formant code de programme, qui exécute le procédé selon l'une au moins des revendications 1 à 7, lorsque le programme d'ordinateur est exécuté sur un ordinateur ou sur une unité de calcul.

11. Produit de programme d'ordinateur comprenant des moyens formant code de programme, qui sont mémorisés sur un support de données lisible à l'ordinateur, qui exécute le procédé selon l'une au moins des revendications 1 à 7, lorsque le produit de programme d'ordinateur est exécuté sur un ordinateur.

Fig.1

Fig.2

Fig. 3

Fig. 4

Simulation Area [um²]

Simulationsbereich